# EUROPÄISCHE PATENTSCHRIFT

(11) **EP 1 271 764 B1**
(45) Veröffentlichungstag und Bekanntmachung des Hinweises auf die Patenterteilung: **11.03.2009**
(21) Anmeldenummer: 01115902.7
(22) Anmeldetag: 29.06.2001
(51) Int. Cl.: H03D 9/06

(54) **Integrierter Diodenmischer**
Integrated diode mixer
Mélangeur à diodes intégré

(43) Veröffentlichungstag der Anmeldung: 02.01.2003
(73) Patentinhaber: Ericsson AB, Stockholm (SE)
(72) Erfinder: Gerhard, Gregor, 71540 Murrhardt (DE); Koch, Stefan, 71570 Oppenweiler (DE); Kern, Stefan, 68753 Waghäusel (DE)
(74) Vertreter: Grosse, Rainer

(56) Entgegenhaltungen:
- EP-A- 0 769 847
- US-A- 5 125 111
- S. MAAS: "A BROADBAND PLANAR DOUBLY BALANCED MONOLITHIC KA-BAND DIODE MIXER" IEEE TRANSACTIONS ON MICROWAVE THEORY AND TECHNIQUES, Bd. 41, Nr. 12, 1. Dezember 1993 (1993-12-01), Seiten 2330-2335, XP000426152 NEW YORK ,US
- J. VILLEMAZET : "NEW COMPACT DOUBLE BALANCED MONOLITHIC DOWN-CONVERTER APPLICATION TO A SINGLE CHIP MMIC RECEIVER FOR SATELLITE EQUIPMENT" IEEE MTT-SB DIGEST, 7. Juni 1998 (1998-06-07), Seiten 853-856, XP000822116 NEW YORK ,US

## Beschreibung

Die Erfindung betrifft einen integrierten Halbleitermischer mit einem Substrat, einem auf dem Substrat angeordneten Radiofrequenz-Balun, einem auf dem Substrat angeordneten Lokaloszillator-Balun, einem auf dem Substrat angeordneten Zwischenfrequenzport und einer auf dem Substrat angeordneten Mischeranordnung, die mit dem Radiofrequenz-Balun, dem Lokaloszillator-Balun und dem Zwischenfrequenzport kommuniziert.

### Stand der Technik

Gattungsgemäße Mischer werden beispielsweise in Funkempfängern verwendet. Sie können als monolithische integrierte Mikrowellenschaltungen unter Verwendung der Mikrostrip-Technologie ausgebildet sein, so dass die Mischerfunktion sehr platzsparend zur Verfügung gestellt werden kann.

Mischer können als Aufwärtskonvertierer und als Abwärtskonvertierer eingesetzt werden. Beim Einsatz von Mischern als Abwärtskonvertierer wird ein Signal mit einer hohen Frequenz ("radio frequency", RF) in ein Signal mit einer niedrigeren Frequenz ("intermediate frequency", Zwischenfrequenz, IF) umgesetzt. Aufwärtskonvertierer wandeln ein Zwischenfrequenzsignal in ein Radiofrequenzsignal um. Abwärtskonvertierer erzeugen ein Zwischenfrequenzsignal, indem das Radiofrequenzsignal mit dem Signal eines Lokaloszillators ("local oscillator", LO) gemischt wird. Aufwärtskonvertierer erzeugen das Radiofrequenzsignal, indem das Zwischenfrequenzsignal mit dem Lokaloszillatorsignal gemischt wird.

Beispiele solcher Mischeranordnungen sind bekannt, z.B. aus US-A-5 125 111, oder IEEE Transactions on Microwave Theory and Techniques, Bd. 41, Nr. 12, 01.12.2993, New York, US. Seiten 2330-2335, S. A. Maas und Kwo wei Chang: "A Broadband, Planar, Doubly Balanced Monolithic Ka-Band Diode Mixer, oder IEEE MTT-SB DIGEST, 07. 06. 1998, New York, US, Seiten 853-856, JF.Villemazet et al.: "NEW COMPACT DOUBLE BALANCED MONOLITHIC DOWN-CONVERTER APPLICATION TO A SINGLE CHIP MMIC RECEIVER FOR SATELLITE EQUIPMENT".

Das Mischen der Signale mit den unterschiedlichen Frequenzen führt in bekannter Weise zur Ausbildung von Summen- und Differenzfrequenzen. Beispielsweise kann die Zwischenfrequenz als Differenzfrequenz das Ergebnis des Mischverfahrens darstellen, welches in weiteren Schaltungen verarbeitet werden kann.

Aufgrund der kurzen Wellenlänge von Mikrowellen kann ein Mikrowellenmischer in einfacher Weise auf einem monolithischen Chip mit integrierten Schaltungen ausgebildet werden. Beispielsweise ist es bekannt, Mischer auf Halbleitersubstraten aus GaAs auszubilden, wobei eine Integration der Mischer mit weiteren Komponenten, um vollständige Aufwärts- beziehungsweise Abwärtskonvertierer zu bilden, die Notwendigkeit erzeugt, zu immer kleineren Mischeranordnungen überzugehen.

Problematisch bei der Verkleinerung der Komponenten ist allerdings, dass sich die unterschiedlichen Signale, die auf demselben Substrat geführt werden, gegenseitig beeinflussen. Beispielsweise kommt es zu einer Beeinflussung zwischen den von dem Radiofrequenz-Balun geführten Signalen und dem von dem Lokaloszillator-Balun geführten Signal. Weiterhin können die genannten Signale der jeweiligen Baluns die Operation der Mischerdioden beeinflussen.

### Vorteile der Erfindung

Die Erfindung baut auf dem gattungsgemäßen integrierten Halbleitermischer dadurch auf, dass der Radiofrequenz-Balun gegen den Lokaloszillator-Balun mittels Durchkontaktierungen elektromagnetisch abgeschirmt ist. Durch derartige Durchkontaktierungen können Isolationen bereitgestellt werden, die zwischen den die unterschiedlichen Signale führenden Bereichen wirken.

Insbesondere ist es nützlich, dass mindestens eine Reihe von Durchkontaktierungen vorgesehen ist. Durch eine Reihe von Durchkontaktierungen lässt sich ein länglicher Bereich in dem Halbleiterchip erzeugen, der in seiner geometrischen Gestalt beispielsweise dem Radiofrequenz-Balun beziehungsweise dem Lokaloszillator-Balun angepasst ist. Somit können die elektromagnetischen Felder, die von dem jeweiligen Balun ausgehen, weitgehend abgeschirmt werden.

Der erfindungsgemäße integrierte Halbleitermischer ist in besonders vorteilhafter Weise dadurch weitergebildet, dass einzelne Durchkontaktierungen durch Widerstände miteinander verbunden sind. Durch diese Widerstände werden unerwünschte Bereiche des elektromagnetischen Feldes unterdrückt beziehungsweise abgeschwächt. Auf diese Weise wird verhindert, dass die Durchkontaktierungsreihen als Resonator mit hoher Güte Q wirken.

Es ist besonders nützlich, dass eine erste Reihe von Durchkontaktierungen in der Nähe des Radiofrequenz-Baluns angeordnet ist und dass eine zweite Reihe von Durchkontaktierungen in der Nähe des Lokaloszillator-Baluns angeordnet ist. Auf diese Weise werden die elektrischen Felder beider Baluns abgeschirmt, so dass die gegenseitige Beeinflussung herabgesetzt wird.

Ebenfalls kann es besonders nützlich sein, dass eine erste Reihe von Durchkontaktierungen zwischen dem Radiofrequenz-Balun und der Mischerdiodenanordnung angeordnet ist und dass eine zweite Reihe von Durchkontaktierungen zwischen dem Lokaloszillator-Balun und der Mischerdiodenanordnung angeordnet ist. Somit können die Beeinflussungen der Mischerdioden herabgesetzt werden, die durch von den Baluns ausgesendete elektromagnetische Felder entstehen.

Der Erfindung liegt die Erkenntnis zugrunde, dass durch das Bereitstellen von Durchkontaktierungen, die insbesondere mit Widerständen untereinander verbunden sind und in Form von Reihen ausgebildet sind, die Isolierung zwischen Lokaloszillator- und Radiofrequenzsignalen beträchtlich, beispielsweise bis zu 10 dB, verbessert werden kann. Dabei ist die konkrete Anordnung der Durchkontaktierungsreihen ein wichtiger Parameter, um eine möglichst gute Isolationswirkung herbeizuführen. Bei kundenspezifischen integrierten Halbleitermischern kann somit individuell durch die Platzierung der Durchkontaktierungsreihen eine besonders gute Isolation individuell bereitgestellt werden.

### Zeichnung

Die Erfindung wird nun mit Bezug auf die begleitende Zeichnung anhand einer bevorzugten Ausführungsform beispielhaft erläutert.

### Dabei zeigt:

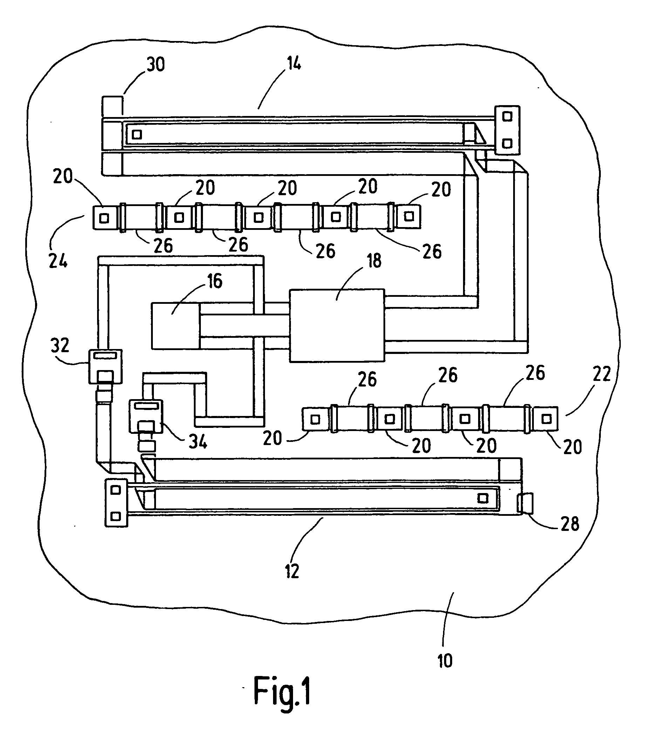

- Figur 1: eine Draufsicht auf einen Teil eines Halbleitersubstrates mit einem erfindungsgemäßen integrierten Halbleitermischer.

### Beschreibung des Ausführungsbeispiels

Figur 1 zeigt eine Draufsicht auf einen Ausschnitt aus einem Halbleitersubstrat 10 mit einem erfindungsgemäßen integrierten Halbleitermischer. Die dargestellte Leitungsanordnung, die auf einer Mikrostrip-Technologie beruht, verbindet unterschiedliche Komponenten miteinander, so dass ein Doppel-Gegentakt-Mischer ("double balanced mixer") gebildet wird. Die Anordnung umfasst einen Radiofrequenz-Balun 12 mit einem Radionfrequenzport 28 und einen Lokaloszillator-Balun 14 mit einem Lokaloszillatorport 30. Im Zentrum der Anordnung sind Mischerdioden 18 vorgesehen. Der Radiofrequenz-Balun 12 konvertiert das Gleichtakt-Radiofrequenzsignal ("unbalanced"), das an dem Radiofrequenzport 28 eingespeist wird, zu einem Gegentakt-Signal ("balanced"), so dass es der Mischerdiodenstruktur 18 über die Serienkondensatoren 32, 34 zugeführt werden kann. In vergleichbarer Weise konvertiert der Lokaloszillator-Balun 14 das beim Lokaloszillatorport 30 zugeführte Gleichtakt-Lokaloszillatorsignal ("unbalanced") zu einem Gegentakt-Signal ("balanced"), so dass auch dieses der Mischerdiodenanordnung 18 zugeführt werden kann. Die jeweiligen Baluns 12, 14 arbeiten so, dass Signale mit einer Phasendifferenz von zirka 180° erzeugt werden. Es wird somit ein Signal zur Verfügung gestellt, dass nicht mehr auf Masse bezogen ist, sondern vielmehr zwischen den beiden vom Balun ausgehenden Leitungen realisiert ist. Mit der Mischerdiodenanordnung 18 ist weiterhin ein Zwischenfrequenzport 16 verbunden, der beispielsweise im Falle der Abwärtskonvertierung der Radiofrequenz das weiterzuverarbeitende Nutzsignal zur Verfügung stellt.

In Nachbarschaft zu den jeweiligen Baluns 12, 14 sind Reihen 22, 24 von Durchkontaktierungen 20 vorgesehen. Diese Reihen 22, 24 von Durchkontaktierungen 20 sind jeweils so gestaltet, dass die einzelnen Durchkontaktierungen 20 durch Widerstände 26 miteinander verbunden sind. Die Durchkontaktierungen 20 stellen eine Isolierung der von dem Lokaloszillatorsignal beziehungsweise dem Radiofrequenzsignal erzeugten elektrischen Felder gegeneinander zur Verfügung. Ferner wird eine Isolierung zwischen dem Radiofrequenz-Balun 12 und der Mischerdiodenanordnung 18 beziehungsweise zwischen dem Lokaloszillator-Balun 14 und der Mischerdiodenanordnung 18 zur Verfügung gestellt.

Die eigentliche Isolierwirkung kommt durch die Erdung der Durchkontaktierungen 20 zustande, während die Widerstände dazu dienen, eine unerwünschte Resonanz der Durchkontaktierungsreihen 22, 24 zu vermeiden.

Die konkrete Anordnung der Durchkontaktierungsreihen 22, 24 kann je nach Anwendungsbeispiel unterschiedlich sein. Unter den Randbedingungen der sonstigen Elemente der Mikrowellenschaltung ist die spezielle Anordnung der Durchkontaktierungsreihen für jeden Fall optimierbar.

## Patentansprüche

1. Integrierter Halbleitermischer mit
- einem Substrat (10),
- einem auf dem Substrat (10) angeordneten Radiofrequenz-Balun (12),
- einem auf dem Substrat (10) angeordneten Lokaloszillator-Balun (14),
- einem auf dem Substrat (10) angeordneten Zwischenfrequenzport (16), und
- einer auf dem Substrat (10) angeordneten Mischerdiodenanordnung (18), die mit dem Radiofrequenz-Balun (12), dem Lokaloszillator-Balun (14) und dem Zwischenfrequenzport (16) kommuniziert,
**dadurch gekennzeichnet, dass** der Radiofrequenz-Balun (12) gegen den Lokaloszillator-Balun (14) mittels Durchkontaktierungen (20) elektromagnetisch abgeschirmt ist.

2. Integrierter Halbleitermischer nach Anspruch 1, **dadurch gekennzeichnet, dass** mindestens eine Reihe (22, 24) von Durchkontaktierungen (20) vorgesehen ist.

3. Integrierter Halbleitermischer nach einem der vorhergehenden Ansprüche, **dadurch gekennzeichnet, dass** einzelne Durchkontaktierungen (20) durch Widerstände (26) miteinander verbunden sind.

4. Integrierter Halbleitermischer nach einem der vorhergehenden Ansprüche, **dadurch gekennzeichnet, dass** eine erste Reihe (22) von Durchkontaktierungen (20) in der Nähe des Radiofrequenz-Baluns (12) angeordnet ist und dass eine zweite Reihe (24) von Durchkontaktierungen (20) in der Nähe des Lokaloszillator-Baluns (14) angeordnet ist.

5. Integrierter Halbleitermischer nach einem der vorhergehenden Ansprüche, **dadurch gekennzeichnet, dass** eine erste Reihe (22) von Durchkontaktierungen (20) zwischen dem Radiofrequenz-Balun (12) und der Mischerdiodenanordnung (18) angeordnet ist und dass eine zweite Reihe (24) von Durchkontaktierungen (20) zwischen dem Lokaloszillator-Balun (14) und der Mischerdiodenanordnung (18) angeordnet ist.

## Claims

1. Integrated semiconductor mixer having
- a substrate (10),
- a radio-frequency balun (12) disposed on the substrate (10),
- a local oscillator balun (14) disposed on the substrate (10),
- an intermediate-frequency port (16) disposed on the substrate (10),
- and a mixer diode array (18), disposed on the substrate (10), that communicates with the radio-frequency balun (12), the local oscillator balun (14), and the intermediate-frequency port (16),
**characterized in that** the radio-frequency balun (12) is electromagnetically shielded from the local oscillator balun (14) by means of through-connections (20).

2. Integrated semiconductor mixer according to claim 1, **characterized in that** at least one row (22, 24) of through-connections (20) is provided.

3. Integrated semiconductor mixer according to one of the preceding claims, **characterized in that** individual through-connections (20) are connected to one another by means of resistors (26).

4. Integrated semiconductor mixer according to one of the preceding claims, **characterized in that** a first row (22) of through-connections (20) is disposed in the vicinity of the radio-frequency balun (12); and that a second row (24) of through-connections (20) is disposed in the vicinity of the local oscillator balun (14).

5. Integrated semiconductor mixer according to one of the preceding claims, **characterized in that** a first row (22) of through-connections (20) is disposed between the radio-frequency balun (12) and the mixer diode array (18); and that a second row (24) of through-connections (20) is disposed between the local oscillator balun (14) and the mixer diode array (18).

## Revendications

1. Mélangeur à semi-conducteurs intégré, comprenant
- un substrat (10),
- un symétriseur de radiofréquence (12) disposé sur le substrat (10),
- un symétriseur d'oscillateur local (14) disposé sur le substrat (10),
- un port de fréquence intermédiaire (16) disposé sur le substrat (10) et
- un agencement de diodes de mélangeur (18), disposé sur le substrat (10), qui communique avec le symétriseur de radiofréquence (12), le symétriseur d'oscillateur local (14) et le port de fréquence intermédiaire (16),
**caractérisé en ce que** le symétriseur de radiofréquence (12) est protégé contre le symétriseur d'oscillateur local (14) de manière électromagnétique au moyen de connexions transversales (20).

2. Mélangeur à semi-conducteurs intégré selon la revendication 1, **caractérisé en ce qu'**il est prévu au moins une série (22, 24) de connexions transversales (20).

3. Mélangeur à semi-conducteurs intégré selon l'une quelconque des revendications précédentes, **caractérisé en ce que** différents connexions transversales (20) sont reliés entre eux par des résistances (26).

4. Mélangeur à semi-conducteurs intégré selon l'une quelconque des revendications précédentes, **caractérisé en ce qu'**une première série (22) de connexions transversales (20) est disposée à proximité du symétriseur de radiofréquence (12) et qu'une deuxième série (24) de connexions transversales (20) est disposée à proximité du symétriseur d'oscillateur local (14).

5. Mélangeur à semi-conducteurs intégré selon l'une quelconque des revendications précédentes, **caractérisé en ce qu'**une première série (22) de connexions transversales (20) est disposée entre le symétriseur de radiofréquence (12) et l'agencement de diodes de mélangeur (18) et qu'une deuxième série (24) de connexions transversales (20) est disposée entre le symétriseur d'oscillateur local (14) et l'agencement de diodes de mélangeur (18).
